# EUROPEAN PATENT SPECIFICATION

(11) **EP 1 954 469 B1**
(45) Date of publication and mention of the grant of the patent: **18.06.2014**
(21) Application number: 06778543.6
(22) Date of filing: 17.08.2006
(51) Int. Cl.: B29C 47/00, B29C 70/52, H01Q 1/42

(54) **METHOD FOR MANUFACTURING AN ANTENNA RADOME FROM COMPOSITE MATERIALS IN CONTINUOUS ACTION**
VERFAHREN ZUR DURCHGEHENDEN HERSTELLUNG EINES ANTENNENRADOMS AUS VERBUNDWERKSTOFFEN
PROCEDE DE FABRICATION D'UN RADOME D'ANTENNE A PARTIR DE MATERIAUX COMPOSITES EN MOUVEMENT CONTINU

(30) Priority: 26.08.2005 FI 20055451
(43) Date of publication of application: 13.08.2008
(73) Proprietor: Exel Composites Oyj, 52701 Mäntyharju (FI)
(72) Inventor: MIETTINEN, Pentti, FI-80260 Joensuu (FI)
(74) Representative: LEITZINGER OY
(86) International application number: PCT/FI2006/050360
(87) International publication number: WO 2007/023207

(56) References cited:
- EP-A1- 0 802 033
- EP-B1- 0 237 970
- GB-A- 2 142 782
- US-A- 5 137 766
- US-A1- 2004 253 429

## Description

The invention relates to a method for manufacturing an antenna radome from composite materials in continuous action by pultrusion technique, said method comprising pulling resin-wetted continuous fibers, mats or fabrics through one or more guides for preforming and then through a heated forming die and finally chopping up the continuous product for radomes of appropriate length.

The invention relates also to a corresponding method for manufacturing a radome in continuous action by extrusion, said method comprising extruding paste of polymer or fiber-reinforced polymer through a forming die and finally chopping up the continuous product for radomes of appropriate length.

Radomes are used, among other things, in conjunction with base station antennae and radar antennae in telecommunications and wireless communication for protecting the antenna (its emitters) from the effects of weather, for directing the radiation beam by means of a reflective layer, and as a support assembly for connections and other antenna accessories. Regarding the prior art, reference can be made e.g. to patent publication EP-0 916 169 B1.

Patent publication FI-96751 discloses a method for manufacturing a radome by casting, such that a layer reflective of electromagnetic waves (i.e. electrically conductive) is cast onto the wall surface or within the wall of a radome. This prior art manufacturing method is tedious and inconvenient to practice.

It is also prior known to manufacture a casing component for a radome in continuous action by a pultrusion method. Radiation reflecting layers are separately applied at a later stage outside or inside such a radome. Thus, the resulting unit will be heavy, in addition to which the reflective layer is exposed to corrosion. Assembling a radome made up by several components involves also extra labor and costs.

GB 2 142 782 A describes a method of producing a radome in accordance with the preamble of claim 5 having coaxial inner and outer cylinder shells formed by extrusion of plastics material. A circular polarising grid network is made by printing on to the outer surface of the cylinders. The polarising grid does not need mounting with regard to the cylinder cells. Nevertheless, a separate stage of printing is needed dafter manufacturing the cylinder cells.

EP 0 802 033 A1 describes a method for providing electromagnetic shielding and diffusion barrier properties of an extruded multiple layer sheet of cylindrical shape. The electromagnetic shielding layer extends over the whole width or circumference of the multiple layer sheet in a complex extruded part to be used in building industry. The product is not applicable as a radome because the magnetic shielding layer is not designed for directing the radiation beam.

An object of the invention is to provide a radome manufacturing method useful for avoiding or substantially mitigating the above problems. Specifically, an object of the invention is to provide a radome manufacturing method of continuous action, which can be used for manufacturing lightweight antenna assemblies, wherein the number of components is reduced and functionality of the antenna is improved.

This object is accomplished with the invention, as defined in the appended claims 1 and 5. Preferred ways of implementing the invention are set forth in the dependent claims.

A method of the invention will now be described in more detail by way of example with reference to the accompanying drawing, in which
- Fig. 1: shows schematically various steps in a manufacturing method or pultrusion according to one embodiment of the invention, and an apparatus for carrying out the method;
- Fig. 2: shows in a larger-scale perspective view one exemplary embodiment for a radome manufactured with a method of the invention;
- Fig. 3: shows one exemplary embodiment for a reflective layer 9 (9') for use in a radome of the invention;
- Fig. 4: shows schematically the implementation of a manufacturing method or extrusion according to a second embodiment of the invention.

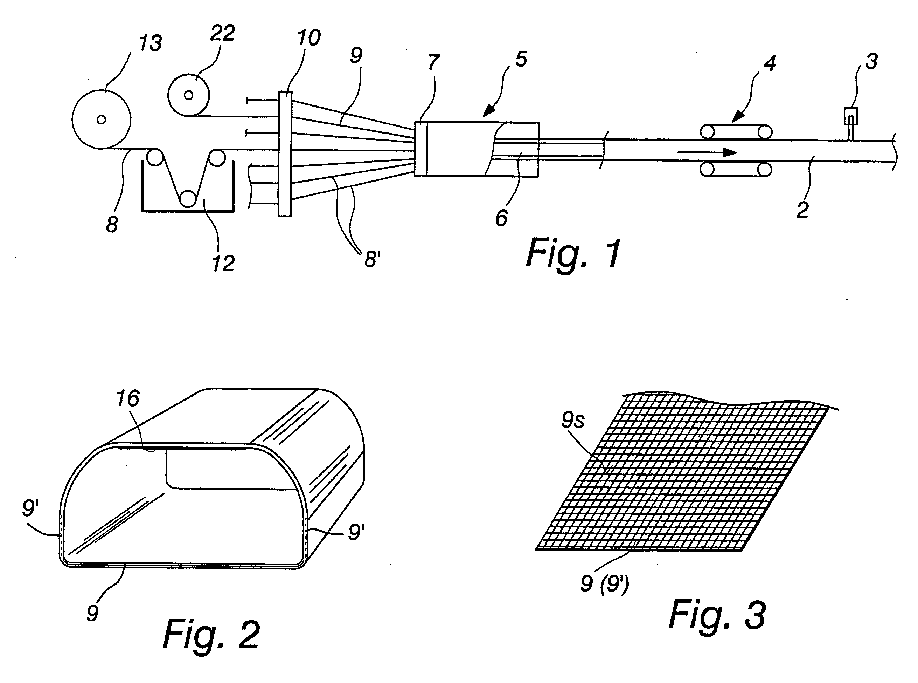

Reinforced fibers, e.g. glass fibers, which are continuous monofilament yarns 8, are pulled from drums 13 through a resin applicator 12. Resin-wetted fibers 8' are pulled further through a guide 10 and by way of an appropriately designed guiding die 7 into a heated mold 5 provided with a core 6. The mold 5 and the core 6 make up a forming die, i.e. the final shape of a profile to be formed is determined by the shape of the mold 5 and the core 6. It can be, as shown e.g. in fig. 2, a circumferentially closed tubular section, having a flat rearward face, arcuate sides, and a slightly arcuate or partially flat forward face. The section shape can also be a flat bar or two separate U-sections, which after manufacturing are coupled by their edges to face each other for a tubular section. Depending on the section shape and employed materials, the guide 10 can be a comb guide, a pipe guide, a hollow guide or a combination of various guides. With certain section shapes (e.g. a flat section), there is no need for the core 6, whereby the mold 5 functions also as a forming die. The wall thickness may vary within the range of 1-6 mm, typically within the range of 1,5-3,0 mm. A continuous product 2 obtained in the mold 5 is drawn by means of a pulling device 4 and the product is chopped up by a cutting saw 3 for radomes of desired length.

The relative positions of materials supplied into the mold 5 are determined by the guide 10 and the guiding die 7.

What is new about the invention is that the layer 9, 9' reflective of electromagnetic radiation is passed in continuous action within a wall or onto the surface of a wall of the product 2 being produced in the forming die 5, 6 for an integral part of the wall. According to one preferred embodiment of the invention, this is performed by feeding the reflective layer 9, 9' as a continuous web or mat through or by means of the guide 10 and further the guiding die 7 to within the reinforced fibers, mats or fabrics 8' for replacing thereby some of the reinforcement 8' destined for a respective location, the wall thickness remaining substantially constant or not increasing at the same rate as the thickness of the reflective layer 9, 9'. In order to enable this without compromising strength, it has been discovered in a preferred embodiment of the invention that adhesion can be enhanced by providing the radiation reflecting layer with a surface structuring, a fabric composition or a pattern of holes, designed not only for improving reflection properties but also for enhancing adhesion to resin. The adhesion to resin can also be improved by subjecting the reflective layer to a chemical surface treatment with silane and/or bonding agents, such as adhesives, or by subjecting the reflective layer to a physical surface treatment with an electric discharge or corona method, a flame treatment or a plasma treatment. One or more of these adhesion enhancing techniques can be involved.

According to one embodiment of the invention, the reflective layer 9, 9' is a thin metal foil, sheet or mat, having its surface provided with a lattice-like striation or raster 9s. According to a second embodiment of the invention, the reflective layer is a metal mat or fabric with a mesh-like structure. The reflective layer can be made at least partially from thin wires or metallized fibers. According to a third embodiment of the invention, the reflective layer 9, 9' is a non-woven mat, which is coated or treated with a conductive material. If the reflective layer is thin, it may additionally include a base layer, e.g. a reinforced plastic laminate, a paper or plastic sheet. The reflective layer 9 can be bonded or applied to the surface of a web or mat, such as a fiberglass mat, functioning as the radome's wall material, prior to its passage into the guide 10.

According to a fourth embodiment of the invention, the conductive layer is a metal foil, sheet or mat, with a pattern of holes therein. The holes can be made by drilling and/or punching. The holes may vary in terms of size and shape. Strength and adhesion can also be improved by having the material, which is displaced out of the way of a hole in the hole-cutting process, deflected to provide an engagement lip. Strength can be improved, especially when the resin is able to penetrate at least sporadically through the reflective layer from the holes or fabric structure. This is beneficial when the radiation reflecting layer 9, 9' is passed in its entirety within the wall of a developing product for an integral component thereof. However, the radiation reflecting layer may also be in attachment to the surface of a radome wall whereby, for adhesion, the resin is in penetrated position within the reflective layer's surface structure or through the holes across the reflective layer's entire thickness, at least sporadically.

The mutual adhesion of a reflection layer and other composite material can also be improved by the selection of a resin used as a bonding agent. Thus, the resin is one or several of the following: polyester, vinyl ester, epoxy or polyurethane. Naturally, all other thermo- or thermosetting plastics common in the manufacture of reinforced plastics may also be relevant and those can be thermoplasticizing or thermosetting according to which manufacturing process is used.

The combined effect of the reflection layer's surface structure, fabric composition or hole pattern and the selection of a resin material enables providing a strength which is sufficient, even if the wall thickness is not increased, at least substantially, at the location of a reflection layer.

A method of the invention is readily applicable for supplying various circumferential regions of a radome with a range of various reflection layers and thereby it is possible to influence the shape of a reflection beam, such that the beam reshapes gradually without sharp lines or stepwise. In the case of fig. 2, the reflection layer 9 embedded within the base of a radome can be otherwise reflective than the reflectors 9' embedded within the side walls, the latter being possibly more transmissive to radiation. Some regions can be provided with a thicker or two or more overlying reflection layers, having resin or some other separately applied bonding agent therebetween.

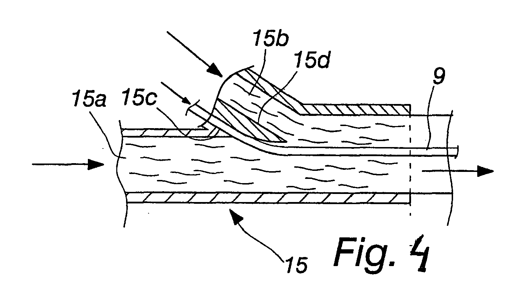

The invention is not limited to the foregoing exemplary embodiment, which describes manufacturing performed by a pultrusion method. Fig. 4 illustrates how continuous manufacturing can be performed also by extrusion, whereby a paste consisting of polymers or fiber-reinforced polymers is extruded through a forming die 15. A reflection layer 9, which possesses properties as described above, is delivered as a continuous web or mat to the forming die 15 for replacing, the same way as in the foregoing exemplary embodiment, some of the paste located in this particular region, such that the wall thickness of a resulting product does not grow, at least not substantially. In view of enhancing adhesion of the reflective layer 9, the above-described methods are applicable also in this case.

In the context of an extrusion method, the design of an extrusion die 15 is preferably implemented in such a way that the supply of materials can be effected in a two-stage fashion (conduits 15a and 15b). The conductive layer 9 must have a separate feeding point 15c and a special forming guide 15d inside the die 15 in a location whereat the rest of the composite paste is still in a plastic state. If the feed of materials is performed in a single stage, the forming guide must be located immediately upstream of the die.

The reflective layer 9 comprises some electrically conductive material, typically a metal such as steel, copper, aluminum, zinc, iron, nickel, bronze, magnesium or the like. Also carbon fiber and/or conductive polymers (PAN) can be used at least as a part of the reflective layer 9, 9'.

It is also feasible to construct the wall of a radome in its entire or partial thickness from carbon-fiber reinforced polymer, thus establishing the reflective layer.

In a preferred embodiment of the invention, an antenna element 16 (fig. 2) can also be manufactured by a continuous process as a permanent component in the wall of a radome 1. Corresponding in design to the reflective layer 9, the antenna element 16 is a conductive layer, which is patterned to form an active antenna element and placed on a wall of the radome opposite to the reflective layer 9. The conductive layers 9 and 16 are spaced by a distance which is typically 1/2 wavelength. For its adjustment, the legs of two U-sections can be engageable with each other in various adjustable overlaps. It is also possible to feed flexible circuit boards in a continuous manufacturing process as part of the radome's wall structure. The same applies to a circuit board blank, which can be patterned afterwards by milling or etching. Conductive layers or circuit boards delivered by a method of the invention can also be used as feeding assemblies for the circuit elements of an antenna or as regulation and filter assemblies for switching a direction or wave ranges. Consequently, antenna radomes manufactured by the method can be used e.g. as directive radar antennae, which only use electronics to switch the direction thereof.

## Claims

1. A method for manufacturing an antenna radome from a composite material in continuous action by pultrusion technique, said method comprising pulling resin-wetted continuous fibers, mats or fabrics (8') through one or more guides (10, 7) for preforming and then through a heated forming die (5) and finally chopping up the pultruded continuous product for radomes of appropriate length, wherein a layer (9, 9') reflective of electromagnetic radiation is supplied as a continuous web or mat onto a predetermined circumferential region or regions of the radome and the web or mat is guided within a wall or onto the surface of the wall of the continuous product (2) developing in continuous action in the forming die (5, 15) for an integral component of the wall.

2. A method as set forth in claim 1, **characterized in that** the layer (9, 9') reflective of radiation is supplied through or by means of one or more guides (10, 7) within or onto the surface of the reinforced fibers, mats or fabrics (8'), and that adhesion of the reflective layer (9. 9') is enhanced by at least one of the following means:
i) the reflective layer is provided with a surface structuring (9s), a fabric composition or a hole pattern capable of improving reflection properties and adhesion;
ii) the reflective layer is subjected to a chemical surface treatment with silane and/or bonding agents, such as adhesives; and
iii) the reflective layer is subjected to a physical surface treatment by an electric discharge or corona method, a flame treatment or a plasma treatment.

3. A method as set forth in claim 1 or 2, **characterized in that** some of the reinforcement (8') destined for a respective region is replaced by the reflective layer (9, 9'), such that the wall thickness of a resulting product remains substantially constant or does not increase at the same rate as the thickness of the reflective layer (9, 9') and its possible base structure.

4. A method as set forth in any of claims 1-3, **characterized in that** the application of a resin comprises using one or more of the following: polyester, vinyl ester, epoxy, polyurethane.

5. A method for manufacturing an antenna radome from a polymer or a composite material in continuous action by extrusion, said method comprising extruding paste of polymer or fiber-reinforced polymer through a forming die (15), chopping up the extruded continuous product for radomes of appropriate length, and applying a layer (9, 9')
reflective of electromagnetic radiation within or onto the surface of each radome, **characterized in that** before the chopping up, the layer (9, 9') reflective of electromagnetic radiation is guided onto a predetermined circumferential region or regions of the radome and is supplied as a continuous web or mat in continuous action within a wall or onto the surface of a wall of the continuous product (2) to be developed or developing in the forming die (15) for an integral component of the wall.

6. A method as set forth in claim 5, **characterized in that** the layer (9, 9') reflective of radiation is supplied to a forming die, and that adhesion of the reflective layer (9. 9') is enhanced by at least one of the following means:
i) the reflective layer is provided with a surface structuring (9s), a fabric composition or a hole pattern capable of improving reflection properties and adhesion;
ii) the reflective layer is subjected to a chemical surface treatment with silane and/or bonding agents, such as adhesives; and
iii) the reflective layer is subjected to a physical surface treatment by an electric discharge or corona method, a flame treatment or a plasma treatment.

7. A method as set forth in claim 5 or 6, **characterized in that** some of the paste presently in a respective region is replaced by the reflective layer (9, 9'), such that the wall thickness of a resulting product remains substantially constant or does not increase at the same rate as the thickness of the reflective layer and its possible base structure.

8. A method as set forth in any of claims 1-7, **characterized in that** the reflective layer (9, 9') is a thin metal foil, sheet or mat, having its surface provided with a lattice-like striation or raster or with a pattern of holes.

9. A method as set forth in any of claims 1-7, **characterized in that** the reflective layer (9, 9') is a metal mat or fabric with a mesh-like structure.

10. A method as set forth in any of claims 1-7, **characterized in that** the reflective layer (9, 9') is a non-woven mat, which is coated or treated with a conductive material.

11. A method as set forth in claim 1 or 5, **characterized in that** an antenna element (16) is manufactured by a continuous process for a permanent component of the radome's (1) wall.

12. A method as set forth in claim 1, 5 or 12, **characterized in that** a flexible circuit board and/or conductive assemblies or regulation and filter assemblies feeding the circuit elements of an antenna are delivered during the course of a continuous manufacturing process for a permanent wall component of the radome perform.

## Patentansprüche

1. Verfahren zur durchgehenden Herstellung eines Antennenradoms aus einem Verbundwerkstoff mittels Strangziehtechnik, wobei das Verfahren ein Ziehen von harzgetränkten kontinuierlichen Fasern, Matten oder Geweben (8') durch eine oder mehrere Führungen (10, 7) zum Vorformen und danach durch ein erhitztes Formgebungswerkzeug (5) und abschließend Ablängen des stranggezogenen durchgehenden Produkts für Radoms von geeigneter Länge, wobei eine Schicht (9, 9'), die elektromagnetische Strahlung reflektiert, als durchgehendes Netz oder durchgehende Matte auf einem im Voraus festgelegten Umfangsbereich oder im Voraus festgelegten Umfangsbereichen des Radoms bereitgestellt wird und das Netz oder die Matte innerhalb einer Wand oder auf der Fläche der Wand des durchgehenden Produkts (2) geführt wird und in einem durchgehenden Vorgang im Formgebungswerkzeug (5, 15) für eine integrierte Komponente der Wand geführt wird.

2. Verfahren nach Anspruch 1, **dadurch gekennzeichnet, dass** die Strahlung reflektierende Schicht (9, 9') durch oder mithilfe von eine(r) oder mehrere(n) Führungen (10, 7) innerhalb oder auf der Oberfläche der verstärkten Fasern, Matten oder Geweben (8') bereitgestellt wird, und dass das Anhaften der reflektierenden Schicht (9, 9') durch wenigstens eines der folgenden Mittel verstärkt wird:
i) die reflektierende Schicht wird mit einer Oberflächenstruktur (9s) versehen, einer Gewebezusammensetzung oder einem Gesamtmuster mit der Fähigkeit, die Reflexionseigenschaften und das Anhaften zu verbessern;
ii) die reflektierende Schicht wird einer chemischen Oberflächenbehandlung mit Silan und/oder Haftvermittlern wie Klebstoffen unterzogen; und
iii) die reflektierende Schicht wird einer physikalischen Oberflächenbehandlung durch ein elektrisches Entladungs- oder Koronaverfahren, eine Flammenbehandlung oder eine Plasmabehandlung unterzogen.

3. Verfahren nach Anspruch 1 oder 2, **dadurch gekennzeichnet, dass** ein Teil der für einen jeweiligen Bereich bestimmten Verstärkung (8') derart durch die reflektierende Schicht (9, 9') ersetzt wird, dass die Wanddicke eines resultierenden Produkts im Wesentlichen konstant bleibt oder nicht im gleichen Ausmaß zunimmt wie die Dicke der reflektierenden Schicht (9, 9') und deren mögliche Basisstruktur.

4. Verfahren nach einem der Ansprüche 1 bis 3, **dadurch gekennzeichnet, dass** das Anwenden eines Harzes ein Anwenden eines oder mehrerer der Folgenden umfasst; Polyester, Vinylester, Epoxy, Polyurethan.

5. Verfahren zur durchgehenden Herstellung eines Antennenradoms aus einem Polymer oder einem Verbundwerkstoff mittels Extrusion, wobei das Verfahren ein Extrudieren von Paste von Polymer oder faserverstärktem Polymer durch ein Formgebungswerkzeug (15), ein Ablängen des extrudierten durchgehenden Produkts für Radoms von entsprechender Länge und Anbringen einer elektromagnetische Strahlung reflektierenden Schicht (9, 9') innerhalb oder auf der Oberfläche jedes Radoms umfasst, **dadurch gekennzeichnet, dass** vor dem Ablängen die elektromagnetische Strahlung reflektierende Schicht (9, 9') auf einem im Voraus festgelegten Umfangsbereich oder im Voraus festgelegten Umfangsbereichen des Radoms bereitgestellt wird und als ein durchgehendes Netz oder eine durchgehende Matte in einem durchgehenden Vorgang innerhalb einer Wand oder auf der Fläche einer Wand des durchgehenden Produkts (2) geführt wird, um im Formgebungswerkzeug (15) sich zu einer integrierten Komponente der Wand zu entwickeln oder entwickelt zu werden.

6. Verfahren nach Anspruch 5, **dadurch gekennzeichnet, dass** die elektromagnetische Strahlung reflektierende Schicht (9, 9') an ein Formgebungswerkzeug bereitgestellt wird, und dass das Anhaften der reflektierenden Schicht (9, 9') durch wenigstens eines der folgenden Mittel verstärkt wird:
i) die reflektierende Schicht wird mit einer Oberflächenstruktur (9s) versehen, einer Gewebezusammensetzung oder einem Gesamtmuster mit der Fähigkeit, die Reflexionseigenschaften und das Anhaften zu verbessern;
ii) die reflektierende Schicht wird einer chemischen Oberflächenbehandlung mit Silan und/oder Haftvermittlern wie Klebstoffen unterzogen; und
iii) die reflektierende Schicht wird einer physikalischen Oberflächenbehandlung durch ein elektrisches Entladungs- oder Koronaverfahren, eine Flammenbehandlung oder eine Plasmabehandlung unterzogen.

7. Verfahren nach Anspruch 5 oder 6, **dadurch gekennzeichnet, dass** ein Teil der gegenwärtig in einem jeweiligen Bereich vorhandenen Paste derart durch die reflektierende Schicht (9, 9') ersetzt wird, dass die Wanddicke eines resultierenden Produkts im Wesentlichen konstant bleibt oder nicht im gleichen Ausmaß zunimmt wie die Dicke der reflektierenden Schicht und deren mögliche Basisstruktur.

8. Verfahren nach einem der Ansprüche 1 bis 7, **dadurch gekennzeichnet, dass** als reflektierende Schicht (9, 9') eine dünne Metallfolie, ein dünnes Metallblech oder eine dünne Matte dient, wobei die Oberfläche mit einer gitterartigen Streifung oder einem gitterartigen Raster oder mit einem Muster von Löchern bereitgestellt ist.

9. Verfahren nach einem der Ansprüche 1 bis 7, **dadurch gekennzeichnet, dass** als reflektierende Schicht (9, 9') eine Metallmatte oder ein Metallgewebe mit einer netzartigen Struktur dient,

10. Verfahren nach einem der Ansprüche 1 bis 7, **dadurch gekennzeichnet, dass** als reflektierende Schicht (9, 9') eine Vliesmatte dient, die mit einem leitfähigen Material beschichtet oder behandelt ist.

11. Verfahren nach Anspruch 1 oder 5, **dadurch gekennzeichnet, dass** ein Antennenelement (16) in einem durchgehenden Vorgang für eine permanente Komponente der Wand des Radoms (1) hergestellt wird.

12. Verfahren nach Anspruch 1, 5 oder 12, **dadurch gekennzeichnet, dass** eine biegsame Leiterplatte und/oder leitfähige Baugruppen oder Regelungs- und Filterbaugruppen zur Speisung der Schaltkreiselemente einer Antenne im Verlauf eines durchgehenden Herstellungsvorgangs für die Durchführung einer permanente Wandkomponente des Radoms geliefert werden.

## Revendications

1. Procédé de préparation d'une antenne radôme à partir d'un matériau composite en une action continue utilisant une technique de pultrusion, ledit procédé comprenant l'étirage de fibres, de nattes ou de tissus (8') continu(e)s de résine humidifiée au travers d'un ou de plusieurs guides (10, 7) pour le préformage et également au travers d'un moule de façonnage chauffé (5) et finalement le hachage du produit continu pultrudé pour des radômes de longueur convenable, dans lequel une couche (9, 9') réfléchissante de rayonnement électromagnétique est appliquée en tant que voile ou nappe continu(e) sur une région périphérique prédéterminée ou sur des régions du radôme et le voile ou la nappe est guidé(e) à l'intérieur d'un mur ou sur la surface du mur du produit continu (2) se développant en une action continue au sein du moule de façonnage (5, 15) pour une partie intégrante du mur.

2. Procédé selon la revendication 1, **caractérisé en ce que** la couche (9, 9') réfléchissante de rayonnement est appliquée au travers de ou à l'aide d'un ou de plusieurs guides (10, 7) à l'intérieur ou sur la surface des fibres, nappes ou tissus (8') renforcé(e)s, et que l'adhérence de la couche réfléchissante (9, 9') est améliorée à l'aide d'au moins un des moyens suivants :
i) la couche réfléchissante est appliquée selon une structuration de surface (9s), selon une composition de tissu ou selon un motif de trous capable d'améliorer les propriétés de réflexion et d'adhérence ;
ii) la couche réfléchissante est sujette à un traitement de surface chimique à l'aide de silane et/ou d'agents de liaison, tels que les adhésifs ; et
iii) la couche réfléchissante est sujette à un traitement de surface physique selon une méthode de décharge électrique ou coronale, selon un traitement à la flamme ou selon un traitement au plasma.

3. Procédé selon la revendication 1 ou la revendication 2, **caractérisé en ce que** certain renforcement (8') destiné à une région respective est remplacé par une couche réfléchissante (9, 9'), de telle sorte que l'épaisseur du mur d'un produit résultant reste essentiellement constante ou n'augmente pas à la même vitesse que l'épaisseur de la couche réfléchissante (9, 9') et de sa possible structure de base.

4. Procédé selon l'une quelconque des revendications 1-3, **caractérisé en ce que** l'application d'une résine comprend l'utilisation d'un ou de plusieurs des composés suivants : vinyle, ester, époxy, polyuréthane.

5. Procédé de préparation d'une antenne radôme à partir d'un polymère ou d'un matériau composite en une action continue utilisant une technique d'extrusion, ledit procédé comprenant l'extrusion de la pâte polymère ou du polymère renforcé par des fibres au travers d'un moule de façonnage (15), le hachage du produit continu extrudé pour des radômes de longueur convenable, et l'application d'une couche (9, 9') réfléchissante d'irradiation électromagnétique à l'intérieur ou sur la surface de chaque radôme, **caractérisé en ce qu'**avant le hachage, la couche (9, 9') réfléchissante de rayonnement électromagnétique est guidée sur une région périphérique prédéterminée ou sur des régions du radôme et est appliquée en tant que voile ou nappe continu(e) en une action continue à l'intérieur d'un mur ou sur la surface d'un mur du produit continu (2) à être développé ou se développant dans le moule de façonnage (15) pour une partie intégrante du mur.

6. Procédé selon la revendication 5, **caractérisé en ce que** la couche (9, 9') réfléchissante de rayonnement est appliquée au moule de façonnage, et que l'adhérence de la couche réfléchissante (9, 9') est améliorée à l'aide d'au moins un des moyens suivants :
i) la couche réfléchissante est appliquée selon une structuration de surface (9s), selon une composition de tissu ou selon un motif de trous capable d'améliorer les propriétés de réflexion et d'adhérence ;
ii) la couche réfléchissante est sujette à un traitement de surface chimique à l'aide de silane et/ou d'agents de liaison, tels que les adhésifs ; et
iii) la couche réfléchissante est sujette à un traitement de surface physique selon une méthode de décharge électrique ou coronale, selon un traitement à la flamme ou selon un traitement au plasma.

7. Procédé selon la revendication 5 ou la revendication 6, **caractérisé en ce qu'**une partie de la pâte dans une région respective est remplacée par une couche réfléchissante (9, 9'), de telle sorte que l'épaisseur du mur d'un produit résultant reste essentiellement constante ou n'augmente pas à la même vitesse que l'épaisseur de la couche réfléchissante et de sa possible structure de base.

8. Procédé selon l'une quelconque des revendications 1-7, **caractérisé en ce que** la couche réfléchissante (9, 9') est une feuille, plaque ou nappe métallique mince, ayant sa surface munie de stries ou de grilles semblables à des réseaux ou munie d'un motif de trous.

9. Procédé selon l'une quelconque des revendications 1-7, **caractérisé en ce que** la couche réfléchissante (9, 9') est une nappe ou un tissu métallique avec une structure de type tamis.

10. Procédé selon l'une quelconque des revendications 1-7, **caractérisé en ce que** la couche réfléchissante (9, 9') est une nappe non tissée, qui est recouverte de ou traitée par un matériau conducteur.

11. Procédé selon la revendication 1 ou la revendication 5, **caractérisé en ce qu'**un élément d'antenne (16) est fabriqué selon un procédé continu pour un composant permanent du mur du radôme (1).

12. Procédé selon la revendication 1, la revendication 5, ou la revendication 12, **caractérisé en ce qu'**une carte à circuit imprimé flexible et/ou des assemblages conducteurs ou des assemblages de contrôle et de filtres alimentant les éléments du circuit d'une antenne sont livrés au cours d'un procédé de préparation d'un composant du mur permanent du radôme.
